(19) Europäisches Patentamt / European Patent Office / Office européen des brevets

(11) **EP 4 701 074 A1**

(12) **EUROPEAN PATENT APPLICATION**
published in accordance with Art. 153(4) EPC

(43) Date of publication:
**25.02.2026 Bulletin 2026/09**

(21) Application number: **24792165.3**

(22) Date of filing: **20.04.2024**

(51) International Patent Classification (IPC):
**H03F 1/02** *(2006.01)*

(52) Cooperative Patent Classification (CPC):
Y02D 30/70

(86) International application number:
**PCT/CN2024/088992**

(87) International publication number:
**WO 2024/217582 (24.10.2024 Gazette 2024/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **20.04.2023 CN 202310425855**

(71) Applicant: **Vanchip (Tianjin) Technology Co., Ltd.
Tianjin 300457 (CN)**

(72) Inventors:
• **CHEN, Gang
Tianjin 300457 (CN)**
• **BAI, Yunfang
Tianjin 300457 (CN)**

(74) Representative: **Wang, Bo
Panovision IP
Ebersberger Straße 3
85570 Markt Schwaben (DE)**

(54) **ADJUSTABLE BALANCED POWER AMPLIFIER, RADIOFREQUENCY FRONT-END MODULE, AND ELECTRONIC DEVICE**

(57) Disclosed in the present invention are an adjustable balanced power amplifier, a radiofrequency front-end module, and a communication terminal. The adjustable balanced power amplifier at least comprises an input power divider, a primary power amplifier, a secondary power amplifier, and an output power combiner. The input power divider divides an input radiofrequency signal into two parts which are respectively amplified by the primary power amplifier and the secondary power amplifier and then are output to the output power combiner. The output power combiner combines the two parts of the signal and outputs same to the outside, an isolation end of the output power combiner being a device having a variable reflection coefficient phase. The adjustable balanced power amplifier can obtain the power boost characteristic the same as that of a conventional balanced power amplifier. In addition, changing the reflection coefficient phase of the isolation end may obtain the optimal efficiency in different power ranges.

FIG. 5

EP 4 701 074 A1

**Description**

**BACKGROUND**

**Technical Field**

The present invention belongs to the technical field of radio frequency integrated circuits, and relates to an adjustable balanced power amplifier, and in particular, to an adjustable balanced power amplifier with an adjustable load line, and also relates to a radio frequency front-end module including the adjustable balanced power amplifier, and a corresponding electronic device.

**Related Art**

In a mobile communication system, to address the issue of excessive attenuation of higher-frequency signals in space, mobile terminals are required to operate at a transmission power of Power Class 2 (that is, PC2 = 26 dBm) for specific bands such as n41 and n77. The transmission power is 3 dBc higher than that of the conventional Power Class 3 (that is, PC3 = 23 dBm), which means that the transmission power is doubled. Therefore, power amplifiers operating in these bands mostly adopt a power combining structure in design to address the challenge of power enhancement. In the prior art, a typical power combination structure includes a balanced power amplifier, a differential power amplifier, and a Doherty amplifier, and the like. Advantages of the balanced power amplifier over a conventional single-channel power amplifier are increased output power, insensitivity to an output load, and a small output reflection coefficient.

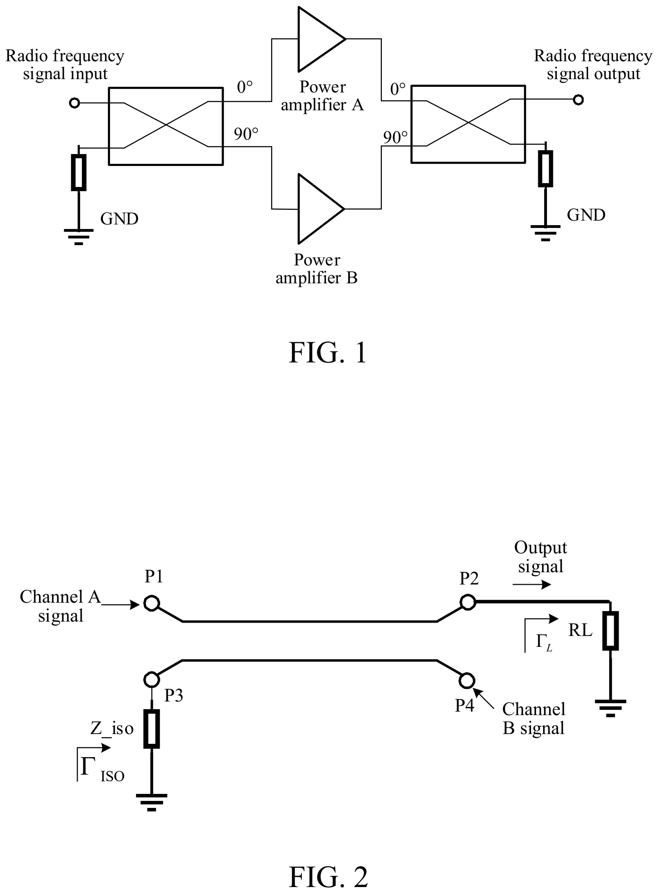

As shown in FIG. 1, a typical conventional balanced power amplifier includes an input power divider, a power amplifier A (that is, a main power amplifier), a power amplifier B (that is, an auxiliary power amplifier), and an output power combiner. The power amplifier A and the power amplifier B are usually two identical power amplifiers. The input power divider and the output power combiner each includes a 90° bridge (Hybrid). Due to a phase shift function of the bridge, a radio frequency signal is in states of in-phase superposition and anti-phase cancellation at an output port and an isolation port respectively. In ideal conditions, an input radio frequency signal is split by the input power divider into two radio frequency signals with a phase difference of 90 degrees. A part of the radio frequency signal is inputted to the power amplifier A, amplified by the power amplifier A, and transmitted to the output power combiner. Another part of the radio frequency signal is inputted to the power amplifier B, amplified by the power amplifier B, and also transmitted to the output power combiner. The output power combiner combines two channels of signals and outputs the radio frequency signal to the outside.

Compared with a single-channel power amplifier, the balanced power amplifier in the prior art can improve output power of 3 dBc. However, since a load line of the balanced power amplifier in the prior art is fixed and unchangeable, efficiency at a backoff power is very low. If different load lines can be switched in different power ranges, efficiencies in different power ranges can be optimized, and operating time of an electronic device can be prolonged.

**SUMMARY**

A primary technical problem to be resolved in the present invention is to provide an adjustable balanced power amplifier with an adjustable load line.

Another technical problem to be resolved in the present invention is to provide a radio frequency front-end module including the adjustable balanced power amplifier.

Still another technical problem to be resolved in the present invention is to provide an electronic device including the adjustable balanced power amplifier.

To achieve the foregoing objectives, the present invention adopts the following technical solutions.

According to a first aspect of embodiments of the present invention, an adjustable balanced power amplifier is provided, including at least an input power divider, a main power amplifier, an auxiliary power amplifier, and an output power combiner, where the input power divider divides an input radio frequency signal into two channels which are respectively amplified by the main power amplifier and the auxiliary power amplifier and then are outputted to the output power combiner, and the output power combiner combines the two channels of the signal and then outputs a combined signal to outside; and an output power ratio of the main power amplifier and the auxiliary power amplifier or a coupling coefficient of the output power combiner is changed, to change a load line of the adjustable balanced power amplifier.

Preferably, an isolation port of the output power combiner is a reflection coefficient phase variable device.

Preferably, in different power ranges, the output power ratio, the coupling coefficient, or a reflection coefficient phase of the reflection coefficient phase variable device is changed to implement different load lines.

Preferably, when the output power ratio of the main power amplifier and the auxiliary power amplifier and the coupling coefficient of the output power combiner are a predetermined combination value, the reflection coefficient phase variable device is adjusted, so that the load lines of the main power amplifier and the auxiliary power amplifier change accordingly, to perform load adjustment based on the change of the power range.

Preferably, the reflection coefficient phase variable device is composed of n switched capacitors and m switched inductors connected in parallel, where n and m are positive integers.

Preferably, the reflection coefficient phase variable device is implemented through a variable phase short-circuit transmission line or a variable phase open-circuit transmission line.

Preferably, the reflection coefficient phase variable device is implemented through a variable capacitor or a variable inductor.

Preferably, the reflection coefficient phase variable device is implemented through any combination of the variable phase short-circuit transmission line, the variable phase open-circuit transmission line, the variable capacitor, and the variable inductor.

According to a second aspect of the embodiments of the present invention, a radio frequency front-end module is provided, including the foregoing adjustable balanced power amplifier.

According to a third aspect of the embodiments of the present invention, an electronic device is provided, including the foregoing adjustable balanced power amplifier.

Compared with the prior art, the adjustable balanced power amplifier provided in the present invention adopts a simple and ingenious circuit design scheme, which can implement flexible adjustment and organic combination of load lines, thereby optimizing efficiencies in different power ranges. The adjustable balanced power amplifier can obtain the same power boost characteristics as the conventional balanced power amplifier, and can obtain an optimal efficiency in different power ranges by changing a reflection coefficient phase of the isolation port. Through the present invention, the adjustable balanced power amplifier may be enabled to maintain efficiency of the power amplifier at a relatively high level in a wider power range, thereby further prolonging the operating time of the electronic device.

## BRIEF DESCRIPTION OF THE DRAWINGS

FIG. 1 is a schematic structural diagram of a conventional balanced power amplifier in the prior art.

FIG. 2 is a schematic diagram showing theoretical calculation of a load line of a balanced power amplifier.

FIG. 3 is a graph showing a variation of a load line of a Channel A power amplifier with a reflection coefficient phase of an isolation port.

FIG. 4 is a graph showing a variation of a load line of a Channel B power amplifier with a reflection coefficient phase of an isolation port.

FIG. 5 is a schematic diagram of a basic structure of an adjustable balanced power amplifier according to an embodiment of the present invention.

FIG. 6 is a schematic diagram of various modified examples of a reflection coefficient phase variable device.

FIG. 7 is a schematic diagram of a reflection coefficient phase variable device composed of a switched capacitor and a switched inductor in parallel.

FIG. 8 is a schematic diagram of a total reflection coefficient area covered by a switched capacitor and a switched inductor in a Smith chart.

FIG. 9 is a schematic diagram of a power added efficiency (PAE) curve of a conventional balanced power amplifier in the prior art.

FIG. 10 is a schematic diagram of a plurality of PAE curves that may be implemented by an adjustable balanced power amplifier according to an embodiment of the present invention.

FIG. 11 is a schematic diagram of an optimized efficiency curve obtained by combining load lines A, B, C, and D according to an embodiment of the present invention.

FIG. 12 is a schematic diagram of a radio frequency front-end module using an adjustable balanced power amplifier according to the present invention.

FIG. 13 is a schematic diagram of an electronic device using an adjustable balanced power amplifier according to the present invention.

## DETAILED DESCRIPTION

Technical contents of the present invention are to be further described in detail below with reference to the accompanying drawings and specific embodiments.

As shown in FIG. 2, in an idealized balanced power amplifier, P1 and P4 are two channels of radio frequency signal input ports, and P2 and P3 are two channels of corresponding radio frequency signal output ports. An S parameter matrix of an output power combiner may be derived as follows:

$$S = \frac{1}{\sqrt{2}} \cdot \begin{bmatrix} 0 & 1 & j & 0 \\ 1 & 0 & 0 & j \\ j & 0 & 0 & 1 \\ 0 & j & 1 & 0 \end{bmatrix} \tag{1}$$

If an isolation port and a load port are matching devices, that is, a reflection coefficient $|\Gamma_{ISO}|$ of the isolation port and a reflection coefficient $|\Gamma_L|$ of the load port are 0, a sum of load lines $Z_A$ and $Z_B$ of a power amplifier A through which a Channel A signal passes and a power amplifier B through which a Channel B signal passes may be calculated:

$$Z_A = Z_B = Z_0 \tag{2}$$

where $Z_0$ is a characteristic impedance of the output power combiner. It may be learned from Equation (2) that an impedance embodied by the idealized balanced power amplifier is a constant impedance, that is, the characteristic impedance of the output power combiner.

Through calculation, an output power of the balanced power amplifier may be obtained as follows:

$$P_{out\_dB} = 20 \cdot log\left(\sqrt{2}\right) = 3\ dBc \tag{3}$$

It may be learned from the foregoing equation that the output power of the balanced power amplifier is 3 dBc higher than that of a single-ended power amplifier, that is, the output power is doubled, thereby achieving a purpose of increasing the output power. However, in a conventional balanced power amplifier, the load line of the power amplifier is the constant impedance, so efficiency configuration cannot be optimized for different power ranges.

In view of the foregoing defects of the prior art, the adjustable balanced power amplifier provided in the embodiments of the present invention adopts an adjustable load line. Detailed description is as follows.

As shown in FIG. 2, if the load port (that is, an L port) is a matching device, that is, the reflection coefficient $|\Gamma_L| = 0$ of the load port, but the isolation port (that is, an ISO port) is a non-matching device, that is, the reflection coefficient $|\Gamma_{ISO}| \neq 0$ of the isolation port. The load lines $Z_A$ and $Z_B$ of the two channels of the power amplifier may be calculated as follows:

$$Z_A = Z_0 \cdot \left( \frac{1 + C \cdot \left(k \cdot \sqrt{1-C^2} - C\right) \cdot |\Gamma_{ISO}| \cdot e^{j\theta_{ISO}}}{1 - C \cdot \left(k \cdot \sqrt{1-C^2} - C\right) \cdot |\Gamma_{ISO}| \cdot e^{j\theta_{ISO}}} \right) \tag{4}$$

$$Z_B = Z_0 \cdot \left( \frac{1 + j \cdot \frac{\sqrt{1-C^2} \cdot \left(C - k \cdot \sqrt{1-C^2}\right) \cdot |\Gamma_{ISO}| \cdot e^{j\theta_{ISO}}}{k}}{1 - j \cdot \frac{\sqrt{1-C^2} \cdot \left(C - k \cdot \sqrt{1-C^2}\right) \cdot |\Gamma_{ISO}| \cdot e^{j\theta_{ISO}}}{k}} \right) \tag{5}$$

$Z_0$ is the characteristic impedance of the output power combiner, $|\Gamma_{ISO}|$ is a reflection coefficient mode of the output port, $\theta_{ISO}$ is a reflection phase of the isolation port, C is a coupling coefficient of the output power combiner, and k is an output power ratio of the power amplifier A and the power amplifier B. It may be learned from Equation 4 and Equation 5 that if the isolation port is a non-matching device, that is, the reflection coefficient $|\Gamma_{ISO}| \neq 0$ of the isolation port, the load lines $Z_A$ and $Z_B$ of two power amplifiers can change with the change of the reflection coefficient phase of the isolation port, so that the load can be adjusted based on the change of the power range.

Let $m = C \cdot \left(k \cdot \sqrt{1-C^2} - C\right)$, then:

$$Z_A = Z_0 \cdot \left( \frac{1 + m \cdot |\Gamma_{ISO}| \cdot e^{j\theta_{ISO}}}{1 - m \cdot |\Gamma_{ISO}| \cdot e^{j\theta_{ISO}}} \right) \tag{6}$$

Let $n = \frac{\sqrt{1-C^2} \cdot \left(C - k \cdot \sqrt{1-C^2}\right)}{k}$, then:

$$Z_B = Z_0 \cdot \left( \frac{1 + j \cdot n \cdot |\Gamma_{ISO}| \cdot e^{j\theta_{ISO}}}{1 - j \cdot n \cdot |\Gamma_{ISO}| \cdot e^{j\theta_{ISO}}} \right) \tag{7}$$

If the isolation port (that is, the ISO port) is connected to a total reflection device, that is, $|\Gamma_{ISO}| = 1$, then

$$Z_A = Z_0 \cdot \left( \frac{1 + m \cdot e^{j\theta_{ISO}}}{1 - m \cdot e^{j\theta_{ISO}}} \right) \qquad (8)$$

$$Z_B = Z_0 \cdot \left( \frac{1 + n \cdot e^{j\left(\frac{\pi}{2} + \theta_{ISO}\right)}}{1 - n \cdot e^{j\left(\frac{\pi}{2} + \theta_{ISO}\right)}} \right) \qquad (9)$$

If $k = 1$, $C = \sqrt{0.5}$, then

$$Z_A = Z_B = Z_0 \qquad (10)$$

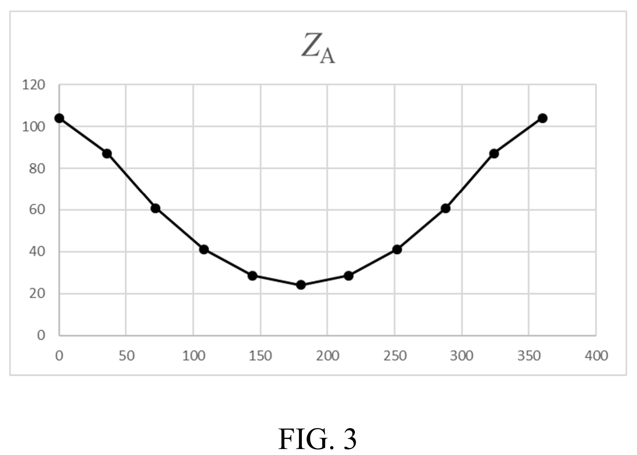

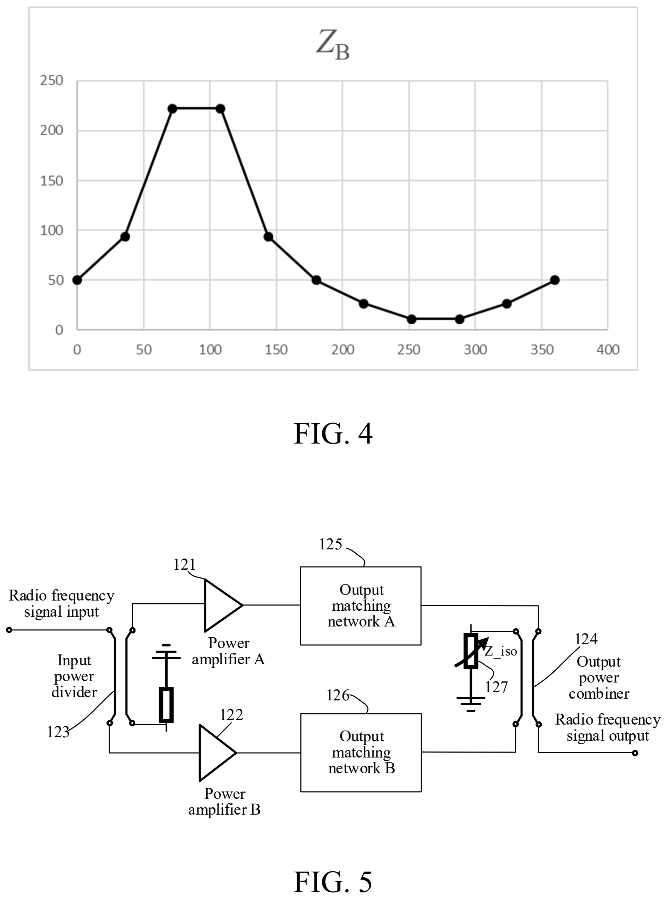

It may be learned from the foregoing equation that when the output power ratio of the two channels of the power amplifiers or the coupling coefficient of the output power combiner is changed, for example, k = 1.52, C = 0.3, and $Z_0$ = 50, the curve of $Z_A$ changing with the reflection coefficient phase $\theta_{ISO}$ of the isolation port is shown in FIG. 3. In FIG. 3, an abscissa is the reflection coefficient phase $\theta_{ISO}$ of the isolation port in degrees, and an ordinate is an impedance value of $Z_0$ in Ohm. A maximum impedance of $Z_A$ is 104 Ohm, and a minimum thereof is 24 Ohm. The curve of $Z_B$ changing with the reflection coefficient phase $\theta_{ISO}$ of the isolation port is shown in FIG. 4. In FIG. 4, an abscissa is the reflection coefficient phase $\theta_{ISO}$ of the isolation port in degrees, and an ordinate is an impedance value of $Z_B$ in Ohm. A maximum value of $Z_B$ impedance is 222 Ohm, and a minimum value thereof is 11 Ohm.

It may be learned seen with reference to the foregoing Equation 4 to Equation 10, FIG. 3, and FIG. 4 that the load line of the power amplifier in the adjustable balanced power amplifier may be changed by changing the output power ratio of the power amplifier A and the power amplifier B, the coupling coefficient of the output power combiner, or the reflection coefficient phase of the reflection coefficient phase variable device, thereby creating conditions for improving efficiency in different power ranges. Relatively speaking, changing the reflection coefficient phase $\theta_{ISO}$ of the isolation port is easier to operate. Therefore, in the subsequent embodiments, a description is provided mainly by using an example in which changing the reflection coefficient phase of the reflection coefficient phase variable device.

FIG. 5 shows a basic structure of an adjustable balanced power amplifier based on the foregoing operating principle. In an embodiment shown in FIG. 5, an adjustable balanced power amplifier includes a power amplifier A (that is, a main power amplifier) 121, a power amplifier B (that is, an auxiliary power amplifier) 122, an input power divider 123, an output power combiner 124, an output matching network A 125, and an output matching network B 126. An isolation port of the output power combiner 124 is a reflection coefficient phase variable device 127. The reflection coefficient phase variable device may be connected to any port in the output power combiner 124 except two signal input ports, and an other port is a signal output port. In ideal conditions, a channel of inputted radio frequency signal is divided into two channels of radio frequency signals with a phase difference of 90 degrees by the input power divider 123. A part of the radio frequency signal with a phase of +45 degrees is inputted to the power amplifier A 121, amplified by the power amplifier, and transmitted to the output power combiner 124 after passing through the output matching network A. An other part of the radio frequency signal with a phase of -45 degrees is transmitted to the power amplifier B 122, amplified by the power amplifier B, and outputted to the output power combiner 124 after passing through the output matching network B. The output power combiner 124 combines two channels of radio frequency signals with a phase difference of 90 degrees and outputs the combined signal to the outside. A biggest difference between the foregoing adjustable balanced power amplifier and the conventional balanced power amplifier in the prior art is that the isolation port of the output power combiner is the reflection coefficient phase variable device. Through this structure, the same power boost characteristic as the conventional balanced power amplifier may be obtained, and an optimal efficiency in different power ranges may be obtained by changing the reflection coefficient phase of the isolation port of the output power combiner simultaneously.

It should be noted that in another embodiment of the adjustable balanced power amplifier, the output matching network A 125 and the output matching network B 126 are optional components, which are not necessarily arranged. In addition, the input power divider may be replaced by an inductor-capacitor phase shifter, a branch line structure, a Wilkinson power divider + a quarter transmission line, or a Lange coupler. The output power combiner may also be replaced by the branch line structure, the Wilkinson power divider + the quarter transmission line, or the Lange coupler. These are conventional technical means generally known to a person skilled in the art. Details are not described herein.

As mentioned earlier, in the embodiment shown in FIG. 5, the isolation port of the output power combiner 124 is the reflection coefficient phase variable device 127. It may be learned according to the foregoing theoretical derivation that when the output power ratio k of the power amplifier A and the power amplifier B and the coupling coefficient C of the output power combiner are a predetermined combination value, the load line $Z_A$ and $Z_B$ of the power amplifier A and the power amplifier B may be changed accordingly by adjusting the reflection coefficient phase variable device of the isolation port of the output power combiner 124, thereby performing load adjustment based on the change of the power range.

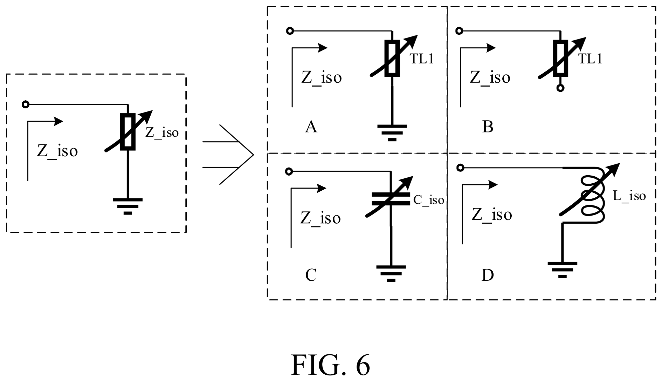

The foregoing reflection coefficient phase variable device 127 may be specifically implemented in a plurality of manners. In a modified example shown in FIG. 6, the reflection coefficient phase variable device 127 may be implemented by a variable phase short-circuit transmission line A and a variable phase open-circuit transmission line B, or may be implemented by a variable capacitor C or a variable inductor D, or may be implemented by any combination of the variable phase short-circuit transmission line A, the variable phase open-circuit transmission line B, the variable capacitor C, or the variable inductor D.

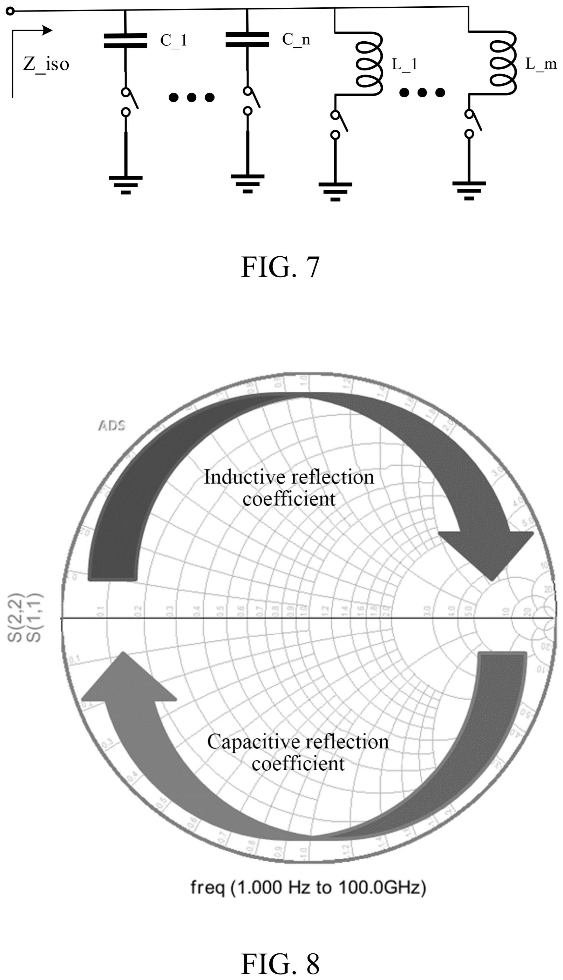

In another modified example shown in FIG. 7, the foregoing reflection coefficient phase variable device 127 may be composed of n switched capacitors and m switched inductors in parallel, where n and m are both positive integers. Through different combinations of capacitance values and inductance values, a required reflection coefficient phase of the isolation port (that is, the ISO port) may be obtained.

FIG. 8 shows a basic principle of changing a reflection coefficient phase. In FIG. 8, an inductive reflection coefficient is an upper half of a Smith chart, where a larger inductance indicates more reflection coefficient changes from left to right along the upper half of the Smith chart. A capacitive reflection coefficient is a lower half of the Smith chart, where a larger capacitance indicates more reflection coefficient changes from right to left along the lower half of the Smith chart. Through combination of different capacitance values and inductance values, theoretically, most positions of a total reflection area in the Smith chart can be covered, that is, most phases of the total reflection coefficient may be achieved.

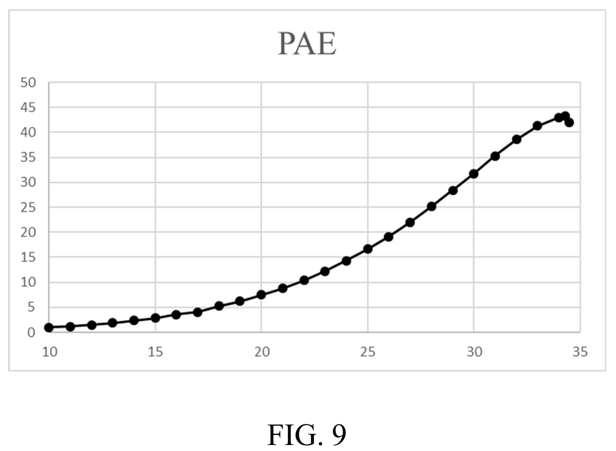

Next, the beneficial technical effects of the adjustable balanced power amplifier provided in the present invention are further discussed with reference to FIG. 9 to FIG. 11. In an embodiment of the present invention, the output power ratio k = 1.52 of the power amplifier A and the power amplifier B and the coupling coefficient C = 0.3 of the output power combiner may be selected to obtain load line curves of the power amplifier as shown in FIG. 3 and FIG. 4.

In this case, the output power of the adjustable balanced power amplifier may be calculated as follows:

$$P_{out\_dB} = 20 \cdot log\big(\sqrt{1 - C^2} + C \cdot k\big) \qquad (11)$$

$k = 1.52$ and $C = 0.3$ are substituted. It may be learned from the foregoing equation that the output power of the adjustable balanced power amplifier is 3 dBc higher than that of the single-ended power amplifier, that is, the power is doubled, which can also meet the purpose of increasing the output power.

On the other hand, in an existing conventional balanced power amplifier, if the load line is kept unchanged, power added efficiency (PAE) curve of the balanced power amplifier is shown in FIG. 9. In FIG. 9, a horizontal axis is the output power of the power amplifier in dBm, and a vertical axis is an efficiency value in percentage. It may be seen from FIG. 9 that the PAE of the power amplifier increases with an increase in the output power, and the efficiency reaches the maximum when approaching a saturation power of 34 dBm. Therefore, the conventional balanced power amplifier has relatively low PAE in a power backoff area. Due to the most commonly used power range of the electronic device represented by a mobile terminal is a medium power range, that is, 15 dBm to 25 dBm. If the efficiency of this power range can be increased, the operating time of the electronic device is to be further extended.

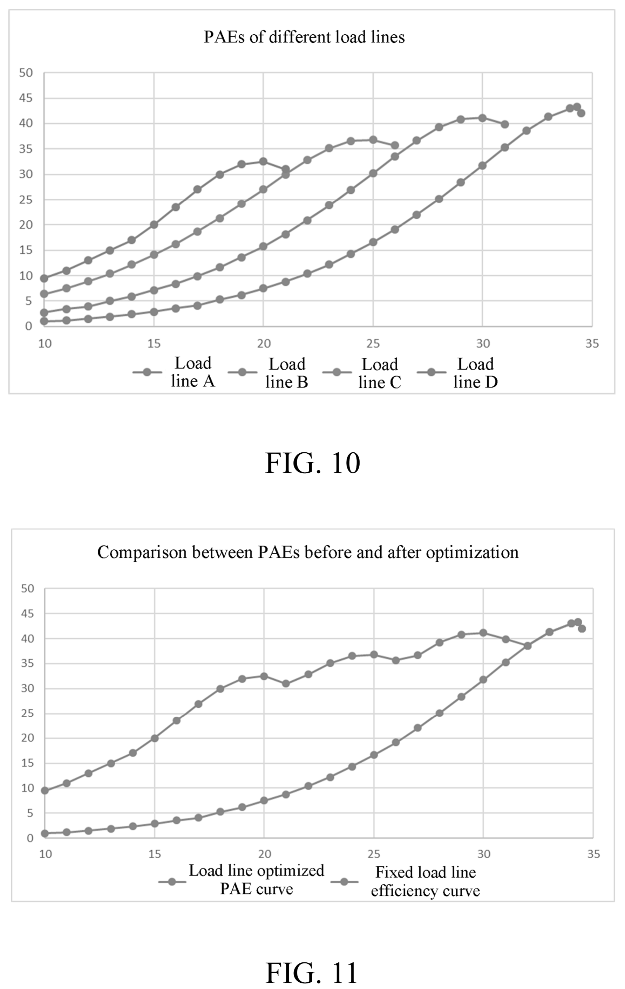

FIG. 10 shows a plurality of PAE curves that may be implemented by an adjustable balanced power amplifier provided in the present invention. In FIG. 10, a load line A < a load line B < a load line C < a load line D, where the load line A is responsible for a power range a (32 dBm to 34 dBm), the load line B is responsible for a power range b (27 dBm to 31 dBm), the load line C is responsible for a power range c (22 dBm to 26 dBm), and the load line D is responsible for a power range d (10 dBm to 21 dBm). A higher load line indicates a lower saturation power, but efficiencies corresponding to different powers can be optimized.

FIG. 11 shows an optimized efficiency curve obtained by combining load lines A, B, C, and D. It may be seen from FIG. 11 that different reflection coefficient phases of the isolation ports can be implemented by adjusting the different combination values of the switched capacitor and the switched inductor in different power ranges, thereby obtaining different load lines. These load lines (for example, A, B, C, and D shown in FIG. 10) are organically combined, and then the efficiencies in different power ranges are optimized, so that the adjustable balanced power amplifier provided in the present invention can maintain the efficiency of the power amplifier above 30% in a wider power range (for example, 18 dBm to 34 dBm). However, due to an unchangeable load line, the conventional balanced power amplifier shown in FIG. 1 has much lower efficiency in the range of 10 dBm to 31 dBm than the adjustable balanced power amplifier provided in the present invention.

It should be noted that each embodiment in the present invention is only exemplary, and functional circuits therein may have other implementation schemes without departing from the essence of the present invention. In addition, various embodiments or variant examples of the present invention are described in a related manner, and identical and similar parts among various embodiments or variant examples may be referred to each other. Each embodiment or variant example highlights a difference from another embodiment, but the embodiments and the variant examples are all implemented based on the operating principle of the adjustable balanced power amplifier. Details are not described herein again.

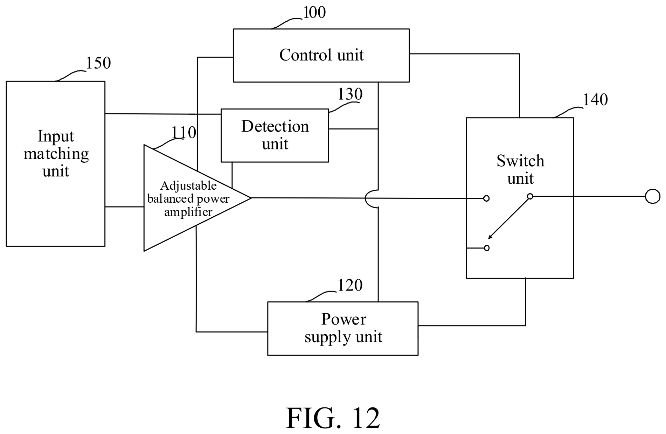

An embodiment of the present invention further provides a radio frequency front-end module. As shown in FIG. 12, the radio frequency front-end module may further include a control unit 100, a power supply unit 120, a detection unit 130, a switch unit 140, and an input matching unit 150 in addition to the foregoing adjustable balanced power amplifier 110. The switch unit 140 is separately connected to the control unit 100, the power supply unit 120, and the adjustable balanced power amplifier 110 in the radio frequency front-end module. The radio frequency signal amplified by the adjustable balanced power amplifier is transmitted to an antenna through the switch unit 140 and sent to a communication base station through the antenna, so that the radio frequency front-end module can send the radio frequency signal to the communication base station. The switch unit 140 herein may be implemented through a single-pole multi-throw switch or a multi-pole multi-throw switch.

In addition, the adjustable balanced power amplifier provided in the present invention may be used in an electronic device as an important part of a communication component such as the radio frequency front-end module. The electronic device mentioned herein refers to a wireless communication device that may be used in a mobile environment and support a plurality of communication standards such as GSM, EDGE, TD_SCDMA, TDD_LTE, and FDD_LTE, which includes a mobile phone, a notebook computer, a tablet computer, an Internet of Vehicles terminal, and the like. In addition, the technical solutions provided in the present invention are also applicable to applications of other radio frequency front-end modules, for example, a communication base station and an intelligent connected vehicle.

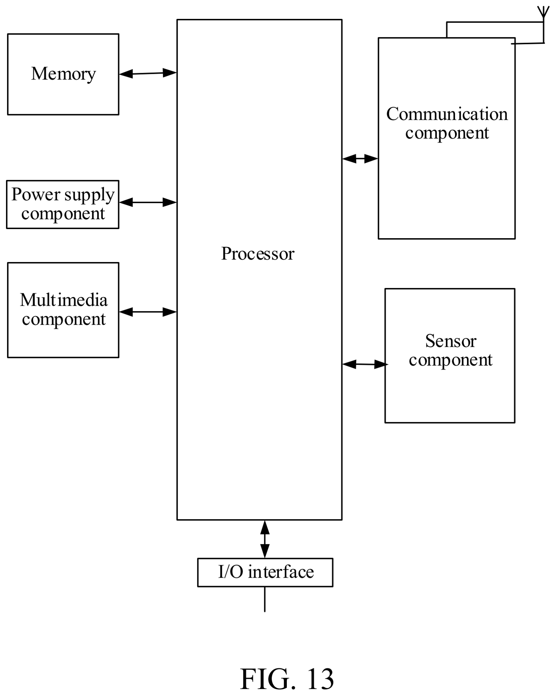

As shown in FIG. 13, the electronic device includes at least a processor and a memory, and may further include a communication component, a sensor component, a power supply component, a multimedia component, and an input/output (I/O) interface according to an actual requirement. The memory, the communication component, the sensor component, the power supply component, the multimedia component, and the I/O interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field-programmable gate array (FPGA), an application-specific integrated circuit (ASIC), a digital signal processing (DSP) chip, or the like. Another communication component, sensor component, power supply component, multimedia component, and the like may be implemented through a general-purpose component. Details are not described herein.

Compared with the prior art, the adjustable balanced power amplifier provided in the present invention adopts a simple and ingenious circuit design scheme, which can implement flexible adjustment and organic combination of load lines, thereby optimizing the efficiencies in different power ranges. The adjustable balanced power amplifier can obtain the same power boost characteristics as the conventional balanced power amplifier, and can obtain the optimal efficiency in different power ranges by changing a reflection coefficient phase of the isolation port. Through the present invention, the adjustable balanced power amplifier may be enabled to maintain efficiency of the power amplifier at a relatively high level in a wider power range, thereby further prolonging the operating time of the electronic device.

The adjustable balanced power amplifier, the radio frequency front-end module, and the electronic device provided in the present invention are described in detail above. For a person of ordinary skill in the art, any obvious changes made to the present invention without departing from the substantive content of the present invention fall within the protection scope of the patent right of the present invention.

Claims

1.  An adjustable balanced power amplifier, comprising at least an input power divider, a main power amplifier, an auxiliary power amplifier, and an output power combiner, wherein the input power divider divides an input radio frequency signal into two channels which are respectively amplified by the main power amplifier and the auxiliary power amplifier and then are outputted to the output power combiner, and the output power combiner combines the two channels of the signal and then outputs a combined signal to outside; and
an output power ratio of the main power amplifier and the auxiliary power amplifier or a coupling coefficient of the output power combiner is changed, to change a load line of the adjustable balanced power amplifier.

2.  The adjustable balanced power amplifier according to claim 1, wherein
an isolation port of the output power combiner is a reflection coefficient phase variable device.

3.  The adjustable balanced power amplifier according to claim 2, wherein
in different power ranges, the output power ratio, the coupling coefficient, or a reflection coefficient phase of the reflection coefficient phase variable device is changed to implement different load lines.

4.  The adjustable balanced power amplifier according to claim 3, wherein

when the output power ratio of the main power amplifier and the auxiliary power amplifier and the coupling coefficient of the output power combiner are a predetermined combination value, the reflection coefficient phase variable device is adjusted, so that the load lines of the main power amplifier and the auxiliary power amplifier change accordingly, to perform load adjustment based on the change of the power range.

**5.** The adjustable balanced power amplifier according to claim 2, wherein
the reflection coefficient phase variable device is composed of n switched capacitors and m switched inductors connected in parallel, wherein n and m are positive integers.

**6.** The adjustable balanced power amplifier according to claim 2, wherein
the reflection coefficient phase variable device is implemented through a variable phase short-circuit transmission line or a variable phase open-circuit transmission line.

**7.** The adjustable balanced power amplifier according to claim 2, wherein
the reflection coefficient phase variable device is implemented through a variable capacitor or a variable inductor.

**8.** The adjustable balanced power amplifier according to claim 6 or 7, wherein
the reflection coefficient phase variable device is implemented through any combination of the variable phase short-circuit transmission line, the variable phase open-circuit transmission line, the variable capacitor, and the variable inductor.

**9.** A radio frequency front-end module, comprising the adjustable balanced power amplifier according to any of claims 1 to 8.

**10.** An electronic device, comprising the adjustable balanced power amplifier according to any of claims 1 to 8.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

## INTERNATIONAL SEARCH REPORT

| | International application No. |
|---|---|
| | **PCT/CN2024/088992** |

| | |
|---|---|
| **A. CLASSIFICATION OF SUBJECT MATTER** | |
| H03F 1/02(2006.01)i | |
| According to International Patent Classification (IPC) or to both national classification and IPC | |

| | |
|---|---|
| **B. FIELDS SEARCHED** | |
| Minimum documentation searched (classification system followed by classification symbols) | |
| IPC: H03F | |
| Documentation searched other than minimum documentation to the extent that such documents are included in the fields searched | |
| Electronic data base consulted during the international search (name of data base and, where practicable, search terms used) | |
| VEN, CNABS, CNTXT, WOTXT, EPTXT, USTXT, CNKI, IEEE: 可调, 平衡, 功率, 放大器, 分配, 主路, 辅助, 辅路, 合成器, 比值, 耦合系数, 负载, 相位, 可变, 系数, adjustable, balancing, power, amplifier, distribution, main, auxiliary, synthesizer, ratio, coefficient, load, phase, variable | |

**C. DOCUMENTS CONSIDERED TO BE RELEVANT**

| Category* | Citation of document, with indication, where appropriate, of the relevant passages | Relevant to claim No. |
|---|---|---|
| PX | CN 116526981 A (VANCHIP (TIANJIN) TECHNOLOGY CO., LTD.) 01 August 2023 (2023-08-01) <br> claims 1-10, and description, paragraph [0060] | 1-10 |
| A | CN 102142812 A (HUAWEI TECHNOLOGIES CO., LTD.) 03 August 2011 (2011-08-03) <br> description, paragraphs [0055]-[0091] | 1-10 |
| A | CN 113364417 A (SUZHOU XIXIN RF MICROELECTRONICS CO., LTD.) 07 September 2021 (2021-09-07) <br> entire document | 1-10 |
| A | CN 115037253 A (CHENGDU FLUXWORKS TECHNOLOGY CO., LTD.) 09 September 2022 (2022-09-09) <br> entire document | 1-10 |
| A | US 2022190793 A1 (SHANGHAI VANCHIP TECHNOLOGIES CO., LTD.) 16 June 2022 (2022-06-16) <br> entire document | 1-10 |

| ☐ Further documents are listed in the continuation of Box C. | ☑ See patent family annex. |
|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **15 July 2024** | **18 July 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
| :--- |
| **PCT/CN2024/088992** |

| Patent document cited in search report | | | Publication date (day/month/year) | Patent family member(s) | | | Publication date (day/month/year) |
| :--- | :--- | :--- | :--- | :--- | :--- | :--- | :--- |
| CN | 116526981 | A | 01 August 2023 | None | | | |
| CN | 102142812 | A | 03 August 2011 | WO | 2012079542 | A1 | 21 June 2012 |
| CN | 113364417 | A | 07 September 2021 | None | | | |
| CN | 115037253 | A | 09 September 2022 | None | | | |
| US | 2022190793 | A1 | 16 June 2022 | CN | 108400774 | A | 14 August 2018 |
| | | | | WO | 2019179487 | A1 | 26 September 2019 |
| | | | | EP | 3771093 | A1 | 27 January 2021 |

Form PCT/ISA/210 (patent family annex) (July 2022)